# EUROPÄISCHE PATENTSCHRIFT

(11) **EP 2 692 215 B1**
(45) Veröffentlichungstag und Bekanntmachung des Hinweises auf die Patenterteilung: **06.01.2016**
(21) Anmeldenummer: 12718887.8
(22) Anmeldetag: 26.03.2012
(51) Int. Cl.: B22D 18/04, B22D 47/00, H05K 3/30, H05K 3/00

(54) **VERFAHREN ZUM HERSTELLEN, INSBESONDERE BEARBEITEN ODER BESTÜCKEN, EINES LEITERPLATTENELEMENTS SOWIE TRÄGER ZUR VERWENDUNG IN EINEM DERARTIGEN VERFAHREN**
METHOD FOR PRODUCING MORE PARTICULARLY PROCESSING OR POPULATING, A CIRCUIT BOARD ELEMENT AND CARRIER FOR USE IN SUCH A METHOD
PROCÉDÉ DE FABRICATION, EN PARTICULIER D'USINAGE OU D'ÉQUIPEMENT, D'UN ÉLÉMENT DE CARTE DE CIRCUITS IMPRIMÉS, AINSI QUE SUPPORT DESTINÉ À ÊTRE UTILISÉ DANS UN TEL PROCÉDÉ

(30) Priorität: 29.03.2011 AT 1772011
(43) Veröffentlichungstag der Anmeldung: 05.02.2014
(73) Patentinhaber: AT & S Austria Technologie & Systemtechnik Aktiengesellschaft, 8700 Leoben-Hinterberg (AT)
(72) Erfinder: FREYDL, Gerhard, A-8700 Leoben-Hinterberg (AT); LEITGEB, Markus, A-8793 Trofaiach (AT)
(74) Vertreter: Miksovsky, Alexander
(86) Internationale Anmeldenummer: PCT/AT2012/000078
(87) Internationale Veröffentlichungsnummer: WO 2012/129582

(56) Entgegenhaltungen:
- JP-A- 4 342 196
- JP-A- 2006 135 041
- US-A1- 2006 112 543

## Beschreibung

Die vorliegende Erfindung bezieht sich auf ein Verfahren zum Herstellen, insbesondere Bearbeiten oder Bestücken, eines Leiterplattenelements, umfassend die folgenden Schritte:
- Bereitstellen eines im wesentlichen vollflächigen Trägers mit einer haftenden Oberflächenschicht,
- Anordnen und Festlegen eines Ausgangsmaterials des herzustellenden, insbesondere zu bearbeitenden oder zu bestückenden Leiterplattenelements auf der haftenden Oberfläche des Trägers,
- Herstellen, insbesondere Bearbeiten oder Bestücken, des auf dem Träger festgelegten Leiterplattenelements in auf dem Träger festgelegter Lage, und
- Entfernen des hergestellten, insbesondere bearbeiteten oder bestückten Leiterplattenelements von dem Träger.

Die Erfindung bezieht sich darüber hinaus auf einen Träger zur Verwendung In einem derartigen Verfahren, wobei der Träger mit einer haftenden Oberflächenschicht zur Festlegung wenigstens eines Leiterplattenelements oder Ausgangsmaterials hierfür ausgebildet ist.

Im Zusammenhang mit der Herstellung von Leiterplattenelementen bzw. Leiterplatten ist es bekannt, eine Mehrzahl von Leiterplatten bzw. Leiterplattenelementen auf bzw. in einem gemeinsamen, plattenartigen Element herzustellen, wobei derartige Leiterplatten üblicherweise jeweils aus einer Mehrzahl von leitenden und isolierenden Schichten und/oder in einer derartigen Leiterplatte integrierten Bauteilen bestehen und/oder mit Bauteilen bestückt werden. Gemäß derart bekannten Herstellungsverfahren erfolgt ein Im wesentlichen vollflächiger Aufbau einer Mehrzahl von Leiterplatten auf bzw. in dem gemeinsamen plattenartigen Element, worauf nach Fertigstellung der Leiterplatten, diese voneinander getrennt werden. Hierbei weist jede Leiterplatte an ihrem Umfangsrand und somit außerhalb eines ein tatsächliches Leiterplattenelement bildenden, im wesentlichen zentralen Bereichs, in welchem die Strukturen zum Aufbau der Leiterplatte und/oder elektronische Bauteile integriert sind, einen entsprechenden Randbereich auf. Dieser ist beispielsweise vorgesehen, um weitere Bearbeitungsschritte einer derartigen Leiterplatte, wie beispielsweise im Rahmen einer Bestückung mit an wenigstens einer Oberfläche festzulegenden Komponenten und/oder eines Einbaus in eine elektrische oder elektronische Vorrichtung durchzuführen, um eine Handhabung und insbesondere ein automatisches Ergreifen einer derartigen Leiterplatte im Rahmen nachfolgender Be- bzw. Verarbeitungsschritte zu ermöglichen. Gemäß derzeit bekannten Verfahrensführungen ist somit davon auszugehen, dass der für den Rahmen bzw. Randbereich der Leiterplatte zur Verfügung zu stellende Umfangsbereich ebenfalls aus üblicherweise kostspieligem Material entsprechend der üblicherweise mehrlagigen Leiterplatte hergestellt wird. Ein derartiger Rand- bzw. Umfangsbereich, welcher für die Funktion der Leiterplatte im Hinblick auf einen üblicherweise mehrlagigen Aufbau aus kostspieligen Materialien nicht erforderlich ist, führt jedoch zu erhöhten Kosten einer derartigen Leiterplatte. Darüber hinaus ist davon auszugehen, dass im Rahmen von bekannten Herstellungsverfahren von Leiterplatten zwischen einzelnen Leiterplattenelementen liegende Bereiche bzw. Flächen des gemeinsamen plattenartigen Elements als Abfall verworfen werden, so dass auch in diesem Zusammenhang erhöhte Kosten für die Herstellung der Leiterplatten bzw. Leiterplattenelemente auflaufen.

Darüber hinaus ist es im Zusammenhang mit der Herstellung von Leiterplatten beispielsweise bekannt, einzelne schadhafte Leiterplatten aus einem gemeinsamen plattenartigen Element zu entfernen, falls diese im Verlauf von Tests bzw. Überprüfungen als schadhaft erkannt wurden, und anstelle von derartigen entfernten schadhaften Leiterplatten einzelne ordnungsgemäße Leiterplatten einzusetzen.

Ein Verfahren sowie ein Träger der eingangs genannten Art sind beispielsweise aus der US 2006/0112543 A1 bekannt geworden, wobei auf eine Reduzierung bzw. Vermeidung von Fehlern bei der Herstellung bzw. Bestückung von Leiterplatten abgezielt wird.

Aus der JP 4 342196 A ist ein Verfahren bekannt geworden, bei welchem durch Vorsehen einer speziellen Markierung eine verbesserte Positionierung eines Bauteils beim Bestücken einer Leiterplatte erzielt werden soll.

Gemäß der JP 2006 135041 A wird auf eine spezielle und sichere Festlegung einer Komponente beim Bestücken einer Leiterplatte abgezielt.

Darüber hinaus sind Verfahren zum gemeinsamen Bearbeiten bzw. Behandeln und Handhaben von Leiterplatten bzw. Leiterplattenelementen der eingangs genannt Art bekannt, wonach in die Leiterplatten jeweils am gesamten Umfang umgebende Träger- bzw. Rahmenelemente üblicherweise mehrere Leiterplatten bzw. Leiterplattenelemente eingesetzt und daran beispielsweise durch ein Verkleben zur Herstellung eines Verbunds bestehend aus wenigstens einem Rahmen- bzw. Trägerelement und einer Mehrzahl von Leiterplatten festgelegt werden. Hiebei kann beispielsweise auf die DE-A 196 00 928, die US-PS 4,689,103 oder die US-PS 5,044,615 verwiesen werden. Nachteilig bei diesen bekannten Verfahren zum Einsetzen von Leiterplatten in ein die Leiterplatten jeweils voliständig umgebendes Rahmenelement zur Herstellung eines gemeinsam handzuhabenden Verbunds ist insbesondere die Tatsache, dass die für die Anordnung der Leiterplatten in dem Rahmenelement vorzusehenden Aufnahmeöffnungen exakt an die Abmessungen der einzusetzenden Leiterplatten angepasst werden müssen und dadurch eine ordnungsgemäße Festlegung beispielsweise mit Hilfe einer Verklebung an den Umfangsrändern der üblicherweise eine vergleichsweise geringe Dicke aufweisenden Leiterplatten und Rahmenelemente äußerst schwierig und aufwendig ist.

Weiters ist es im Zusammenhang mit der Herstellung von Leiterplattenelementen bzw. Leiterplatten bekannt, derartige Leiterplattenelemente mit Rahmen- bzw. Trägerelementen zu verbinden, welche derartige Leiterplattenelemente oder Leiterplatten lediglich über einen Teilbereich des Umfangs umgeben, um die oben geschilderten Nachteile eines vollständigen Einpassens wenigstens teilweise zu beheben. In diesem Zusammenhang wird beispielsweise auf die WO 2010/102315 verwiesen.

Nachteilig an den bekannten Verfahren ist darüber hinaus, dass insbesondere in Anpassung an die Abmessungen der aufzunehmenden und in weiterer Folge zu behandelnden bzw. zu bearbeitenden Leiterplatten bzw. Leiterplattenelemente auch die Abmessungen der Rahmen- bzw. Trägerelemente entsprechend unterschiedlich gewählt werden, so dass in nachfolgenden Bearbeitungsvorgängen, beispielsweise in Bestückungslinien bei einem Wechsel der zu behandelnden bzw. zu bearbeitenden Leiterplatten ein entsprechend hoher Zeitaufwand für eine Umrüstung derartiger Bearbeitungslinien bzw. -straßen in Anpassung an unterschiedliche Abmessungen insbesondere des von dem jeweils wenigstens einen Rahmen- bzw. Trägerelement und der Mehrzahl von Leiterplatten gebildeten Verbunds erforderlich ist.

Nachteilig bei sämtlichen bekannten Verfahren unter Verwendung von Rahmen-bzw. Trägerelementen ist die Tatsache, dass für derartige Rahmen- bzw. Trägerelemente zusätzliche Material eingesetzt werden muss, welches nach einer Fertigstellung der Leiterplattenelemente bzw. Leiterplatten entsorgt wird und somit zu zusätzlichen Kosten bei der Herstellung, insbesondere Bearbeitung oder Bestückung derartiger Leiterplattenelemente führt. Darüber hinaus ist ein entsprechender Aufwand für eine Vereinzelung der Leiterplattenelemente bzw. Leiterplatten nach deren Herstellung bzw. Fertigstellung unter Trennung von den eingesetzten Rahmen- bzw. Trägerelementen erforderlich.

Die vorliegende Erfindung zielt darauf ab, ein Verfahren sowie einen Träger zur Durchführung eines derartigen Verfahrens der eingangs genannten Art Im Zusammenhang mit einer Herstellung, insbesondere Bearbeitung oder Bestückung von Leiterplattenelementen bzw. Leiterplatten dahingehend weiterzubilden, dass die oben genannten Nachteile des Standes der Technik vermieden werden, und insbesondere ein Verfahren sowie einen Träger zur Verfügung zu stellen, bei welchen ein zusätzlicher Materialeinsatz für Rahmen- bzw. Trägerelementen minimiert oder weitestgehend eliminiert werden kann und auch auf zusätzliche Arbeitsschritte zur Trennung der hergestellten bzw. fertiggestellten Leiterplattenelemente von derartigen Rahmen- bzw. Trägerelementen verzichtet oder deren Durchführung stark vereinfacht werden kann.

Zur Lösung dieser Aufgaben ist ein Verfahren zum Herstellen, insbesondere Bearbeiten oder Bestücken, eines Leiterplattenelements der eingangs genannten Art im wesentlichen dadurch gekennzeichnet, dass ein mit einer von einer flachen Oberfläche abweichenden Oberfläche ausgebildetes Leiterplattenelement auf dem Träger in einer eine zu der Oberflächenkontur des Leiterplattenelements komplementäre Profilierung aufweisenden Ausnehmung bzw. Vertiefung in der Oberfläche des Trägermaterials angeordnet wird.

Während bei einer Herstellung bzw. Bearbeitung eines Leiterplattenelements in einem frühen Herstellungs- bzw. Verarbeitungszustand derartige Leiterplattenelemente üblicherweise eine im wesentlichen ebene bzw. vollflächige Struktur aufweisen, so dass eine einfache und zuverlässige Festlegung auf einem ebenfalls vollflächigen bzw. ebenen, mit einer haftenden Oberfläche versehenen Träger möglich wird, ist insbesondere in weitergehenden Herstellungs- bzw. Bearbeitungsschritten teilweise bekannt oder davon auszugehen, dass beispielsweise bei einer Ausbildung von unterschiedlichen Schichten bzw. Lagen oder einer Anordnung bzw. wenigstens teilweise Integration von Bauteilen In bzw. an einem derartigen Leiterplattenelement von einer ebenen Oberfläche abweichende Konturen bzw. Teilbereiche eines derartigen Leiterplattenelements vorgesehen bzw. zu erwarten sind. Für eine zuverlässige und ordnungsgemäße Festlegung eines derartigen Leiterplattenelements wird erfindungsgemäß vorgeschlagen, dass ein mit einer von einer flachen Oberfläche abweichenden Oberfläche ausgebildetes Leiterplattenelement auf dem Träger In einer eine zu der Oberflächenkontur des Leiterplattenalements komplementäre Profilierung aufweisenden Ausnehmung bzw. Vertiefung angeordnet wird. Derart kann nicht nur eine gewünschte exakte Positionierung des Leiterplattenelements auf dem Träger erfolgen, sondern es kann durch eine entsprechende Profilierung des Trägers der von einer ebenen Oberflächenkontur abweichenden Ausbildung eines anzuordnenden bzw. festzulegenden Leiterp lattenelements Rechnung getragen werden.

Durch die vorgeschlagenen Schritte gelingt es, auf den Einsatz wenigstens eines mit einem herzustellenden, insbesondere zu bearbeitenden oder zu bestückenden Leiterplattenelement zu verbindenden und auf die Konturen eines derartigen Leiterplattenelements wenigstens teilweise abgestimmten Rahmen- bzw. Trägerelements im wesentlichen vollständig zu verzichten, da vorgeschlagen wird, einen im wesentlichen vollflächigen Träger mit einer haftenden Oberfläche zur Verfügung zu stellen, auf welchem ein Leiterplattenelement bzw. das Ausgangsmaterial hierfür für vorzunehmende Herstellungsschritte unter Vermittlung der haftenden Oberfläche temporär festgelegt werden kann. In einem auf dem Träger auf der haftenden Oberfläche festgelegten bzw. angeordneten Zustand wird eine Herstellung, insbesondere Bearbeitung oder Bestückung eines derartigen Leiterplattenelements vorgenommen, wonach nach einer Fertigstellung bzw. Beendigung der Bearbeitungs- oder Bestückungsschritte das Leiterplattenelement in einfacher Weise von der haftenden Oberfläche des Trägerelements entfernt wird und einer weiteren Be- bzw. Verarbeitung unterworfen werden kann.

Es Ist unmittelbar ersichtlich, dass im Gegensatz zum bekannten Stand der Technik auf einen Einsatz von auf die Konturen eines zu bearbeitenden Leiterplattenelements wenigstens teilweise abzustimmenden Rahmen- bzw. Trägerelements vollständig verzichtet werden kann, so dass der Materialeinsatz bei der Herstellung eines Leiterplattenelements bzw. einer Leiterplatte entsprechend reduziert oder minimiert werden kann, da Im Gegensatz zum bekannten Stand der Technik derartige Rahmen- bzw. Trägerelemente nicht unter Vermehrung der Gesamtkosten bei der Herstellung entsorgt werden müssen. Ein derartiger vollflächiger Träger mit einer haftenden Oberfläche kann somit in einfacher und zuverlässiger Weise für eine Vielzahl von Herstellungs- bzw. Bearbeitungsvorgängen von Leiterplattenelementen eingesetzt werden, wodurch die Kosten für die Herstellung derartiger Leiterplattenelemente entsprechend reduziert bzw. minimiert werden können. Durch einen derart verringerten Materialeinsatz für das Träger- bzw. Rahmenelement lässt sich neben einer Kostenersparnis auch eine entsprechende Schonung der Ressourcen und somit der Umwelt erzielen.

Darüber hinaus kann mit dem erfindungsgemäßen Verfahren ein in einfacher Weise an Herstellung- bzw. Bearbeitungsanlagen angepasstes einheitliches Format des Trägers im wesentlichen unabhängig von einem zu bearbeitenden oder herzustellenden Leiterplattenelement zur Verfügung gestellt werden, so dass auf aufwendige Anpassungen an gegebenenfalls unterschiedliche Formate von Herstellungs- oder Bearbeitungsanlagen von Leiterplattenelementen oder Leiterplatten verzichtet werden kann.

Weiters ist es durch das erfindungsgemäße Verfahren möglich, gegebenenfalls einzelne Leiterplattenelemente in derartigen Herstellungs- oder Bearbeitungsanlagen zu bearbeiten, so dass im Gegensatz zum Stand der Technik nicht entsprechend großflächige Formate, auf welchen üblicherweise eine Vielzahl von zumeist identen Leiterplattenelementen angeordnet ist, derartigen Bearbeitungs- oder Herstellungsvorgängen unterzogen werden müssen. Es ermöglicht somit das erfindungsgemäße Verfahren eine Einzelanfertigung von Leiterplattenelementen oder beispielsweise während eines Erprobungszeitraums von Prototypen, wobei durch derartige Einzelanfertigungen wiederum ein entsprechend reduzierter Materialeinsatz insbesondere in einem Entwicklungsstedium von Leiterplatten oder Leiterplattenelementen erzielbar ist.

Darüber hinaus wird durch das erfindungsgemäße Verfahren durch Bereitstellen eines Trägers mit einer haftenden Oberfläche zur Festlegung eines Leiterplattenelements ermöglicht, beispielsweise unterschiedliche Leiterplattenelemente einem gemeinsamen Herstellungs- oder Bearbeitungsvorgang zu unterwerfen, da entsprechend den Anforderungen eine gewünschte Anordnung und Festlegung derartiger, gegebenenfalls unterschiedlicher Leiterplattenelemente auf einem derartigen gemeinsamen Träger in einfacher und zuverlässiger Weise vorgenommen werden kann.

Durch Anordnung und Festlegung jeweils eines einzelnen Leiterplattenelements auf dem Träger kann auch eine entsprechend exakte Positionierung und Ausrichtung vorgenommen werden, da im Gegensatz zum bekannten Stand der Technik nicht eine Ausrichtung von großflächigen Formaten, welche üblicherweise eine Vielzahl von Leiterplattenelementen enthalten, in einem Herstellungs- oder Bearbeitungsvorgang vorgenommen wird, wobei beispielsweise durch Toleranzen einer gegenseitigen Anordnung einer derartigen Vielzahl von Leiterplattenelementen in einem gemeinsamen Format entsprechende Ungenauigkeiten bei der tatsächlichen Positionierung einzelner Leiterplattenelemente in einem Format möglich sind. Durch die erfindungsgemäß vorgeschlagene Anordnung und Festlegung bzw. Positionierung jedes einzelnen Leiterplattenelements werden derartige Ungenauigkeiten im Hinblick auf eine relative Positionierung einer derartigen Vielzahl von Leiterplattenelementen vermieden. Es können hierbei Festlegungen eines Leiterplattenelements mit Genauigkeiten bzw. einer Präzision von besser als ± 30 µm, insbesondere bis zu ± 10 µm erzielt werden. Dadurch können beispielsweise entsprechend kleinbauende Elemente in einem Leiterplattenelement genau lokalisiert und beispielsweise zuverlässig kontaktiert werden.

Darüber hinaus wird durch das erfindungsgemäße Verfahren durch einfaches Entfernen eines Leiterplattenelements nach dem Herstellungs- oder Bearbeltungsvorgang eine Vereinfachung der Verfahrensschritte dahingehend möglich, dass auf aufwendige Vereinzelungs- bzw. Trennschritte einzelner Leiterplattenelemente von Rahmen- bzw. Trägerelementen verzichtet werden kann.

Für eine besonders zuverlässige und genaue Positionierung einzelner Leiterplattenelemente oder Leiterplatten auf dem mit einer haftenden Oberfläche ausgebildeten Träger wird gemäß einer bevorzugten Ausführungsform des erfindungsgemäßen Verfahrens vorgeschlagen, dass das Leiterplattenelement auf der haftenden Oberfläche des Trägers unter Bezugnahme auf wenigstens zwei in bzw. an dem Leiterplattenelement vorgesehene Markierungen, insbesondere Registrationsmarkierungen angeordnet wird. Wie bereits oben kurz erwähnt, gelingt somit durch Vorsehen von Markierungen bzw. Registrationsmarken auf jedem Leiterplattenelement eine zuverlässige und genaue Positionierung desselben auf dem Träger für eine nachfolgende Bearbeitung oder Fertigstellung eines derartigen Leiterplattenelements unabhängig von einer Positionierung gegebenenfalls weiterer Leiterplattenelemente auf dem Träger.

Für eine Herstellung bzw. Bearbeitung des Leiterplattenelements wird gemäß einer weiters bevorzugten Ausführungsform vorgeschlagen, dass das Leiterplattenelement gemeinsam mit dem Träger bei einem Herstellen, insbesondere Bearbeiten oder Bestücken, einer Behandlung unter gegenüber Umgebungsbedingungen erhöhtem Druck und/oder erhöhter Temperatur unterworfen wird. Hierbei sind derartige Herstellungs- oder Behandlungsschritte unter gegenüber Umgebungsbedingungen erhöhtem Druck und/oder erhöhter Temperatur im Rahmen einer Herstellung oder Bearbeitung von Leiterplattenelementen bzw. Leiterplatten für sich gesehen bekannt.

In einer auf einem mit einer haftenden Oberfläche ausgebildeten Träger festgelegten bzw. angeordneten Lage kann eine Vielzahl von unterschiedlichen Herstellungs- bzw. Bearbeitungsschritten an einem derartigen Leiterplattenelement vorgenommen werden, wobei in diesem Zusammenhang gemäß einer weiters bevorzugten Ausführungsform des erfindungsgemäßen Verfahrens vorgeschlagen wird, dass beim Herstellen, insbesondere Bearbeiten oder Bestücken, des Leiterplattenelements ein Aufbauen bzw. Ausbilden von wenigstens einer weiteren Schicht bzw. Lage des Leiterplattenelements, ein Strukturieren wenigstens einer Schicht bzw. Lage des Leiterplattenelements, ein Festlegen von und/oder Bestücken mit wenigstens einem aktiven oder passiven Bauteil auf bzw. in dem Leiterplattenelement vorgenommen wird bzw. werden. Es ist somit unmittelbar ersichtlich, dass während einer im wesentlichen provisorischen oder temporären Anordnung bzw. Festlegung eines Leiterplattenelements im wesentlichen sämtliche Herstellungs- bzw. Bearbeitungsvorgänge an einem Leiterptattertelement bzw. einer Leiterplatte vorgenommen werden können, welche im Rahmen einer Herstellung von derartigen Leiterplattenelementen bekannt sind.

Im Rahmen des erfindungsgemäßen Verfahrens kann eine Vielzahl von unterschiedlichen Leiterplattenelementen bzw. Leiterplatten einer Herstellung, insbesondere Bearbeitung oder Bestückung, unterworfen werden, wobei in diesem Zusammenhang gemäß einer weiters bevorzugten Ausbildung vorgeschlagen wird, dass das Leiterplattenelement von einem starren, flexiblen oder starr-flexiblen Leiterplattenelement, einem Leiterplatten-Zwischenprodukt bzw. -Halbfertigprodukt oder einer starren, flexiblen oder starr-flexiblen Leiterplatte gebildet wird.

Wie bereits oben angemerkt, wird durch Einsatz des erfindungsgemäßen Verfahrens nicht nur die Möglichkeit einer Herstellung oder Bearbeitung von einzelnen Leiterplattenelementen geschaffen, sondern es kann auch Insbesondere unter Optimierung der Ausnutzung des Platzes auf einem derartigen Träger eine Mehrzahl von gegebenenfalls unterschiedlichen Leiterplattenelementen einer Behandlung unterworfen werden, wobei in diesem Zusammenhang gemäß einer weiters bevorzugten Ausführungsform des erfindungsgemäßen Verfahrens vorgeschlagen wird, dass eine Mehrzahl von Leiterplattenelementen auf dem Träger angeordnet bzw. festgelegt wird und einem gemeinsamen Herstellungsvorgang, insbesondere Bearbeitungs- oder Bestückungsvorgang unterworfen wird.

Neben einer Bearbeitung gegebenenfalls einer Vielzahl von Leiterplattenelementen durch Anordnung bzw. Festlegung auf einem gemeinsamen Träger wird darüber hinaus vorgeschlagen, dass wenigstens zwei nebeneinander auf dem Träger angeordnete Leiterplattenelemente während der Herstellung, insbesondere Bearbeitung oder Bestückung miteinander verbunden werden, wie dies einer weiters bevorzugten Ausführungsform des erfindungsgemäßen Verfahrens entspricht. Es kann somit nicht nur eine besonders zuverlässige und unter Vermeidung von Rahmen- bzw. Trägerelementen, welche nachfolgend entsorgt werden müssen, kostengünstige Herstellung oder Bearbeitung von Leiterplattenelementen erfolgen, sondern es kann durch eine entsprechende Anordnung auf einem gemeinsamen Träger in entsprechender räumlicher Nahebeziehung während derartiger Herstellungs- oder Bearbeitungsvorgänge in einfacher und zuverlässiger Weise auch eine Kopplung bzw. Verbindung von gegebenenfalls unterschiedlichen bzw. einen unterschiedlichen Aufbau aufweisenden Leiterplattenelementen zur Herstellung eines entsprechenden Leiterplattenelements oder einer Leiterplatte durchgeführt werden. Derart lassen sich beispielsweise starre und flexible Bereiche einer Leiterplatte durch Anordnung auf einem derartigen gemeinsamen Träger in einfacher und zuverlässiger Weise unter Einhaltung entsprechend genauer relativer Positionierungen koppeln bzw. verbinden.

Zur Lösung der eingangs genannten Aufgaben wird darüber hinaus ein Träger der eingangs genannten Art zur Durchführung des erfindungsgemäßen Verfahrens zur Verfügung gestellt, welcher Im wesentlichen dadurch gekennzeichnet ist, dass die Oberfläche des Trägers zur Anordnung eines Leiterplattenelements mit einer zu einer von einer flachen Oberfläche abweichenden Außenoberfläche einer Leiterplatte komplementaren Profillerung in der Oberfäche des Trägermaterials ausgebildet ist. Durch eine derartige Bereitstellung eines oftmals verwendbaren Trägers mit einer haftenden Oberfläche gelingt eine einfache und zuverlässige Festlegung wenigstens eines Leiterplattenelements oder Ausgangsmaterials hierfür, um eine zuverlässige Herstellung, insbesondere Bearbeitung oder Bestückung, eines derartigen Leiterplattenelements zu ermöglichen. Für eine zuverlässige Positionierung und Aufnahme von Leiterplattenelementen oder Leiterplatten, welche eine von einer ebenen Oberflächenkontur abweichende Kontur, beispielsweise durch bereits erfolgte Aufnahme von elektronischen Bauteilen und/oder Aufbau von unterschiedlichen Schichten bzw. Lagen aufweisen, wird erfindungsgemäß vorgeschlagen, dass die Oberfläche des Trägers zur Anordnung eines Leiterplattenelements mit einer zu einer von einer flachen Oberfläche abweichenden Außenoberfläche einer Leiterplatte komplementären Profilierung ausgebildet ist.

Für eine Herstellung bzw. Bearbeitung von Leiterplattenelementen oder Leiterplatten gelangen oftmals, wie dies bereits oben erwähnt wurde, gegenüber Umgebungsbedingungen erhöhte Druck- und/oder Temperaturbedingungen zur Anwendung, wobei neben den Materialien für derartige Leiterplattenelemente auch zur Beibehaltung der gewünschten genauen Positionierung derselben das Trägermaterial entsprechend formstabil und gegenüber erhöhten Druck- und/oder Temperaturbedingungen widerstandsfähig sein muss. In diesem Zusammenhang wird gemäß einer bevorzugten Ausführungsform für den Träger vorgeschlagen, dass das Material des Trägers gewählt ist aus Metallen, wie beispielsweise Aluminium, Stahl oder dgl., oder aus formstabilen und hochtemperaturfesten, insbesondere faserverstärkten Kunststoffen, wie Duroplasten oder Thermoplasten, wie beispielsweise Polyarylenen, Polyarylenether, Polyarylenetherketonen, Polyarylaten, Polyarylensulfiden, Polyarylenethersulfonen, Polyarylenamiden, Polyimiden.

Neben einer entsprechenden Widerstandsfähigkeit und Formbeständigkeit des Trägermaterials muss auch das für die haftende Oberfläche eingesetzte Material den im Rahmen einer Herstellung oder Bearbeitung von Leiterplatten oder Leiterplattenelementen herrschenden Druck- und/oder Temperaturbedingungen widerstehen können, wobei in diesem Zusammenhang gemäß einer weiters bevorzugten Ausführungsform vorgeschlagen wird, dass die haftende Oberfläche des Trägers gebildet ist von formstabilen und hochtemperaturfesten Kunststoffen, wie beispielsweise auspolymerisierten, adhesiven, niedrigmolekularen Silikonharzen, wie insbesondere vernetzten Polymethylsiloxanen oder Polymethylphenylsiloxanen, etc.

Die Erfindung wird nachfolgend anhand von in der beiliegenden Zeichnung schematisch dargestellten Ausführungsbeispielen näher erläutert. In dieser zeigen:
Fig. 1 eine erste Ausführungsform eines erfindungsgemäßen Trägers zur Durchführung des erfindungsgemäßen Verfahrens mit einer Mehrzahl von darauf angeordneten bzw. festgelegten Leiterplattenelementen, wobei Fig. 1a eine Draufsicht in Richtung des Pfeils IA der Fig. 1b zeigt und Fig. 1b eine Schnittansicht gemäß der Linie IB-IB darstellt;
Fig. 2 in einer zu Fig. 1 ähnlichen Darstellung eine abgewandelte Ausführungsform eines erfindungsgemäßen Trägers zur Durchführung des erfindungsgemäßen Verfahrens, wobei Fig. 2a wiederum eine Draufsicht und Fig. 2b wiederum einen Schnitt ähnlich der Darstellung gemäß Fig. 1 zeigen;
Fig. 3 eine Detailansicht in größerem Maßstab, wobei angedeutet ist, dass auf einem auf einem Träger angeordneten bzw. festgelegten Leiterplattenelement ein Aufbau einer weiteren Schicht oder Lage oder eine Anordnung eines elektronischen Bauteils vorgenommen wird;
Fig. 4 in einer zu Fig. 3 ähnlichen Darstellung eine abgewandelte Ausführungsform, wobei eine Verbindung bzw. Kopplung von unterschiedlichen Leiterplattenelementen in auf dem Träger angeordneter Lage angedeutet ist; und
Fig. 5 schematisch ein Verfahrensdiagramm, in welchem einzelne Verfahrensschritte des erfindungsgemäßen Verfahrens dargestellt sind.

Im Rahmen der vorliegenden Beschreibung werden Ausgangsmaterialien für ein herzustellendes bzw. zu bearbeitendes Leiterplattenelement ebenfalls bereits teilweise als Leiterplattenelement bezeichnet, da es sich überwiegend bereits um ein Halbfertigprodukt oder Zwischenprodukt handelt, welches gemäß der üblichen Nomenklatur sowohl vor als auch nach einer Bearbeitung als Leiterplattenelement bezeichnet wird.

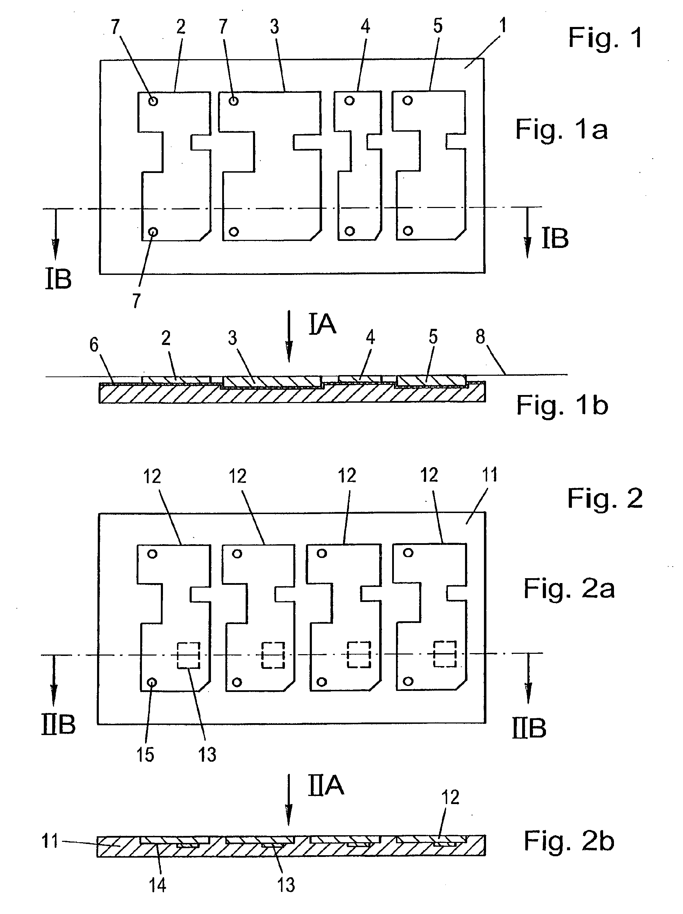

Aus der Darstellung gemäß Fig. 1 ist ersichtlich, dass auf einem allgemein mit 1 bezeichneten, im wesentlichen vollflächigen Träger eine Mehrzahl von Leiterplattenelementen 2, 3, 4, 5 bzw. Ausgangsmaterialien hierfür angeordnet und unter Vermittlung einer schematisch mit 6 angedeuteten Haftschicht auf dem Träger 1 festgelegt ist. Hierbei ist in Fig. 1 schematisch angedeutet, dass insbesondere unter einer Optimierung der Platzausnutzung die Leiterplattenelemente 2 bis 5 unterschiedliche Größen und Abmessungen aufweisen.

Für eine zuverlässige und genaue Positionierung ist darüber hinaus insbesondere aus Fig. 1a ersichtlich, dass die Leiterplattenelemente 2 bis 5 jeweils Markierungen, insbesondere Registrationsmarkierungen 7 aufweisen, mit welchen eine exakte und zuverlässige Positionierung der Leiterplattenelemente 2 bis 5 auf dem Träger 1 und unabhängig von bereits auf dem Träger 1 gegebenenfalls angeordneten oder festgelegten weiteren Leiterplattenelementen vorgenommen werden kann.

Zur Erzielung einer gemeinsamen Be- bzw. Verarbeitungshöhe, welche in Fig. 1b schematisch durch die Linie 8 angedeutet ist, ist aus dieser Darstellung darüber hinaus ersichtlich, dass unter Berücksichtigung von unterschiedlichen Dicken der einzelnen Leiterplattenelemente die Elemente 3 und 5 in entsprechend abgesetzten Teilbereichen des Trägers 1 angeordnet sind.

Nach einer Fertigstellung bzw. Beendigung der Herstellungs- bzw. Bearbeitungsvorgänge, wie dies nachfolgend anhand der zusätzlichen Figuren erörtert werden wird, lassen sich die Leiterplattenelemente 2 bis 5 in einfacher und zuverlässiger Weise wiederum von der Oberfläche des Trägers 1 entfernen, so dass auf aufwendige Vereinzelungs- bzw. Trennschritte zur Entfernung von mit einzelnen Leiterplattenelementen verbundenen Rahmen- bzw. Trägerelementen verzichtet werden kann.

Der Träger 1 kann in weiterer Folge für weitere Be- bzw. Verarbeitungsvorgänge von weiteren Leiterplattenelementen eingesetzt werden, so dass hierdurch nicht nur der Materialaufwand bei der Herstellung der Leiterplattenelemente bzw. Leiterplatten 2 bis 5 reduziert werden kann, sondern durch einen verringerten Materialeinsatz auch eine entsprechende Schonung der Ressourcen und Umwelt erzielt werden kann.

Bei der Darstellung gemäß Fig. 2 ist ersichtlich, dass auf einem mit 11 bezeichneten Träger eine Mehrzahl von in diesem Fall gleichen Leiterplattenelementen 12 bzw. Ausgangsmaterialien hierfür angeordnet ist. Die Leiterplattenelemente 12 weisen beispielsweise bereits einen integrierten elektronischen Bauteil 13 auf, wodurch sich eine von einer ebenen Oberfläche abweichende Oberflächenköntur der einzelnen Leiterplattenelemente 12 ergibt, wie dies insbesondere aus der Darstellung gemäß Fig. 2b ersichtlich ist. Für eine ordnungsgemäße Anordnung und Festlegung der Leiterplattenelemente 12 ist somit bei dem Träger 11 vorgesehen, dass er entsprechend der Oberflächenkontur der mit den Bauteilen 13 versehenen Leiterplattenelemente 12 mit einer entsprechend konturierten Oberfläche ausgebildet ist, wobei derartige profilierte bzw. abgesetzte Teilbereiche des Trägers mit 14 angedeutet sind.

Eine exakte Positionierung und Ausrichtung der einzelnen Leiterplattenelemente 12 erfolgt wiederum unter Verwendung von mit 15 angedeuteten Markierungen bzw. Registrationsmarkierungen.

Eine Darstellung einer haftenden Oberfläche bzw. Klebeschicht ist in Fig. 2, insbesondere in Fig. 2b der Einfachheit halber weggelassen.

Ebenso wie bei der Ausführungsform gemäß Fig. 1 kann nach einer Fertigstellung bzw. Beendigung des Herstellungs- bzw. Bearbeitungsvorgangs eine einfache Entfernung bzw. Entnahme der einzelnen Leiterplattenelemente 12 von dem Träger 11 vorgenommen werden, so dass wiederum die bereits mehrfach erwähnten Vorteile im Hinblick auf eine Vermeidung von aufwendigen Trenn- bzw. Vereinzelungsschritten als auch eine Materialeinsparung und Schonung der Ressourcen erzielbar sind.

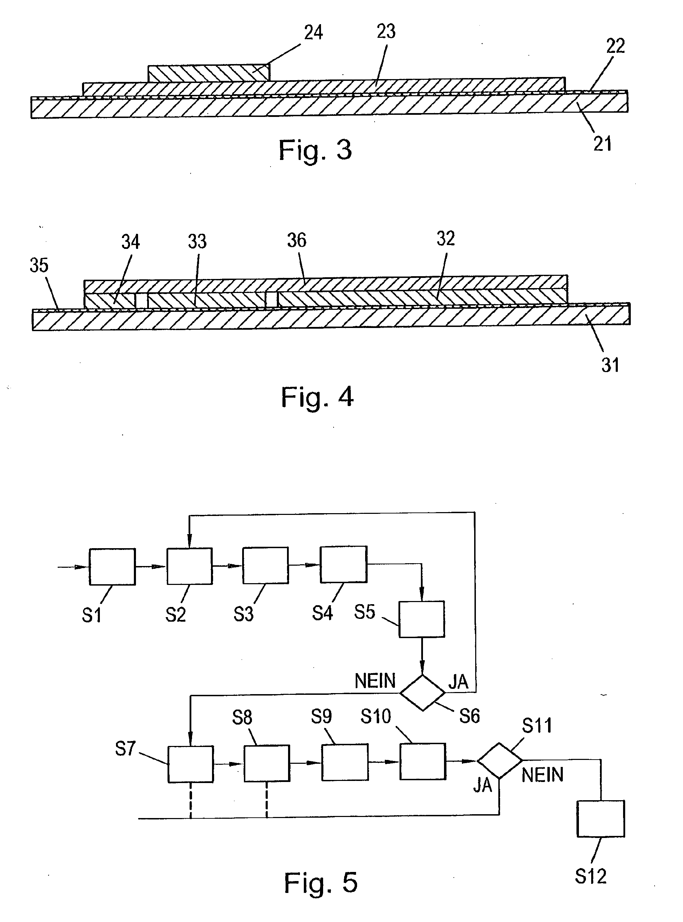

Bei der Darstellung gemäß Fig. 3 ist angedeutet, wie in auf eine Anordnung bzw. Festlegung einzelner Leiterplattenelemente auf einem Träger folgenden Be- bzw. Verarbeitungsschritten eine entsprechende Be- bzw. Verarbeitung erfolgt. Hierbei ist in Fig. 3 ein Träger mit 21 bezeichnet, wobei über eine mit 22 angedeutete Klebeschicht bzw. haftende Oberfläche eine Festlegung eines Leiterplattenelements 23 erfolgt. Im Rahmen eines nach der Festlegung bzw. Anordnung vorzunehmenden Herstellungs- bzw. Bearbeitungsvorgangs wird bei der Ausführungsform gemäß Fig. 3 auf dem Leiterplattenelement 23 eine weitere Schicht bzw. Lage 24 angeordnet, wobei dies gemäß an sich bekannten Schritten bei der Herstellung von Leiterplatten bzw. Leiterplattenelementen vorgenommen werden kann.

Anstelle eines Aufbaus einer weiteren Schicht bzw. Lage 24 kann bei der Ausführungsform gemäß Fig. 3 beispielsweise eine Bestückung mit einem elektronischen Bauteil auf der Oberfläche des auf dem Träger 21 angeordneten bzw. festgelegten Leiterplattenelements 23 vorgesehen sein.

Bei der abgewandelten Ausführungsform gemäß Fig. 4 ist angedeutet, dass auf einem Träger 31 eine Mehrzahl von Leiterplattenelementen 32, 33 und 34 unter Vermittlung einer haftenden Oberfläche bzw. Klebeschicht 35 angeordnet ist. Im Rahmen einer Be- bzw. Verarbeitung der Mehrzahl von Leiterplattenelementen 32, 33 und 34, welche in einer entsprechenden räumlichen Nahebeziehung auf dem Träger 31 angeordnet sind, erfolgt beispielsweise unter bzw. durch Ausbildung oder Anordnung einer weiteren Schicht bzw. Lage 36 eine Verbindung bzw. Kopplung der miteinander zu verbindenden Leiterplattenelemente 32, 33 und 34, welche gegebenenfalls einen unterschiedlichen Aufbau aufweisen können.

In dem schematischen Verfahrensdiagramm von Fig. 5 ist angedeutet, dass in einem Schritt S1 jeweils ein einzelnes Leiterplattenelement bzw. eine einzelne Leiterplatte von einem nicht näher dargestellten Vorrat oder einem vorangehenden Herstellungs- bzw. Bearbeitungsprozess zugeführt wird. In einem Schritt S2 erfolgt eine Aufnahme des Leiterplattenelements beispielsweise durch eine automatische Handhabungsvorrichtung, worauf in einem Schritt S3 eine Ausrichtung des Leiterplattenelements insbesondere unter Berücksichtung der vorgesehenen Markierungen bzw. Registrationsmarkierungen erfolgt und nachfolgend beispielsweise über die automatische Handhabungsvorrichtung in einem Schritt S4 eine Anordnung und Festlegung eines derartigen einzelnen Leiterplattenelements auf dem Träger erfolgt, wie dies beispielsweise in Fig. 1 und 2 dargestellt ist.

Nach einer gegebenenfalls vorzunehmenden Überprüfung der Positionierung des Leiterplattenelements auf dem Träger gemäß Schritt S5 erfolgt in Schritt S6 eine Überprüfung bzw. Entscheidung, ob weitere Leiterplattenelemente auf dem Träger angeordnet und festgelegt werden. Falls die Entscheidung in Schritt S6 JA ist, erfolgt eine Rückkehr zu Schritt S2 und eine Wiederholung der Schritte S2 bis S5 zur Anordnung und Festlegung weiterer Leiterplattenelemente auf dem Träger.

Falls die Entscheidung in Schritt S6 NEIN ist, so dass entweder nur ein einzelnes Leiterplattenelement bearbeitet oder behandelt werden soll oder entsprechend den Anforderungen oder dem zur Verfügung stehenden Platz keine weiteren Leiterplattenelemente auf dem Träger angeordnet werden sollen oder können, erfolgt in einem Schritt S7 ein Transport des Trägers mit dem darauf angeordneten wenigstens einen Leiterplattenelement zu einer nachfolgenden Herstellungs- bzw. Bearbeitungsstation, wobei in einem Schritt S8 beispielsweise eine Aufbringung einer Lötpaste erfolgt, worauf in einem Schritt S9 nach einer gegebenenfalls vorzunehmenden Vermessung eine Anordnung einer weiteren Schicht oder Lage oder eines auf dem Leiterplattenelement anzuordnenden elektronischen Bauteils erfolgt, wie dies in Fig. 3 und 4 schematisch angedeutet wurde. Nach einer derartigen Anordnung einer zusätzlichen Schicht bzw. Lage oder eines elektronischen Bauteils gemäß dem Schritt S9 erfolgt beispielsweise in einem Reflow-Ofen gemäß dem Schritt S10 eine Festlegung der zusätzlichen Schicht oder des elektronischen Bauteils unter Einsatz von an sich bekannten Herstellungs- oder Verarbeitungsverfahren bei der Herstellung eines Leiterplattenelements oder einer Leiterplatte.

In einem Schritt S11 erfolgt eine Überprüfung, ob weitere Be- bzw. Verarbeitungsschritte durchzuführen sind. Falls die Entscheidung im Schritt S11 JA ist, erfolgt eine Rückkehr entsprechend den Anforderungen oder den durchzuführenden Herstellungs- oder Bearbeitungsvorgängen beispielsweise zu Schritt S7 und S8 und eine entsprechend oftmalige Wiederholung der Herstellungs- bzw. Bearbeitungsschritte oder abgewandelter Herstellungs- bzw. Bearbeitungsschritte, welche jedoch der Einfachheit halber in Fig. 5 nicht getrennt dargestellt sind.

Falls die Entscheidung in Schritt S11 NEIN ist und somit der Herstellungs- oder Bearbeitungsvorgang des wenigstens einen Leiterplattenelements auf dem Träger abgeschlossen ist, erfolgt nachfolgend gemäß dem Schritt S12 eine einfache Entfernung des wenigstens einen bearbeiteten Leiterplattenelements von dem Träger, worauf der Träger für weitere Herstellungs- bzw. Bearbeitungsvorgänge durch Anordnung bzw. Festlegung wenigstens eines weiteren Leiterplattenelements wiederum zur Verfügung steht und beispielsweise in Schritt S4 wiederum eingesetzt werden kann.

Für einen Einsatz in bei der Herstellung bzw. Bearbeitung von Leiterplattenelementen oder Leiterplatten an sich bekannten Bearbeitungsschritten ist das Material des Trägers 1, 11, 21 bzw. 31 beispielsweise gewählt aus Metallen, wie beispielsweise Aluminium, Stahl oder dgl., oder aus formstabilen und hochtemperaturfesten, insbesondere faserverstärkten Kunststoffen, wie Duroplasten oder Thermoplasten, wie beispielsweise Polyarylenen, Polyarylenether, Polyarylenetherketonen, Polyarylaten, Polyarylensulfiden, Polyarylenethersulfonen, Polyarylenamiden, Polyimiden oder dgl.

Für eine sichere und zuverlässige Festlegung wenigstens eines Leiterplattenelements auf dem Träger während der Durchführung der entsprechenden Bearbeitungs- oder Herstellungsvorgänge ist darüber hinaus vorgesehen, dass die Klebeschicht 6, 22 bzw. 35 des Trägers 1, 11, 21 bzw. 31 beispielsweise gebildet ist von formstabilen und hochtemperaturfesten Kunststoffen, wie beispielsweise auspolymerisierten, adhesiven, niedrigmolekularen Silikonharzen, wie insbesondere vernetzten Polymethylsiloxanen oder Polymethylphenylsiloxanen, etc.

## Patentansprüche

1. Verfahren zum Herstellen, insbesondere Bearbeiten oder Bestücken, eines Leiterplattenelements, umfassend die folgenden Schritte:
- Bereitstellen eines im wesentlichen vollflächigen Trägers (1, 11, 21, 31) mit einer haftenden Oberflächenschicht (6, 22, 35),
- Anordnen und Festlegen eines Ausgangsmaterials des herzustellenden, insbesondere zu bearbeitenden oder zu bestückenden Leiterplattenelements (2, 3, 4, 5, 12, 23, 32, 33, 34) auf der haftenden Oberfläche (6, 22, 35) des Trägers (1, 11, 21, 31),
- Herstellen, insbesondere Bearbeiten oder Bestücken, des auf dem Träger (1, 11, 21, 31) festgelegten Leiterplettenelements (2, 3, 4, 5, 12, 23, 32, 33, 34) in auf dem Träger (1, 11, 21, 31) festgelegter Lage, und
- Entfernen des hergestellten, insbesondere bearbeiteten oder bestückten Leiterplattenelements (2, 3, 4, 5, 12, 23, 32, 33, 34) von dem Träger (1, 11, 21, 31),
**dadurch gekennzeichnet, dass** ein mit einer von einer flachen Oberfläche abweichenden Oberfläche ausgebildetes Leiterplattenelement (12) auf dem Träger (11) in einer eine zu der Oberflächenkontur des Leiterplattenelements (12) komplementäre Profilierung aufweisenden Ausnehmung bzw. Vertiefung (14), in der Oberfläche des Trägermaterials angeordnet wird.

2. Verfahren nach Anspruch 1, **dadurch gekennzeichnet, dass** das Leiterplattenelement (2, 3, 4, 5, 12, 23, 32, 33, 34) auf der haftenden Oberfläche (6, 22, 35) des Trägers (1, 11, 21, 31) unter Bezugnahme auf wenigstens zwei in bzw. an dem Leiterplattonelement vorgesehene Markierungen (7, 15), insbesondere Registrationsmarkierungen angeordnet wird.

3. Verfahren nach Anspruch 1 oder 2, **dadurch gekennzeichnet, dass** das Leiterplattenelement (2, 3, 4, 5, 12, 23, 32, 33, 34) gemeinsam mit dem Träger (1, 11, 21, 31) bei einem Herstellen, insbesondere Bearbeiten oder Bestücken, einer Behandlung unter gegenüber Umgebungsbedingungen erhöhtem Druck und/oder erhöhter Temperatur unterworfen wird.

4. Verfahren nach Anspruch 1, 2 oder 3, **dadurch gekennzeichnet, dass** beim Herstellen, insbesondere Bearbeiten oder Bestücken, des Leiterplattenelements (2, 3, 4, 5, 12, 23, 32, 33, 34) ein Aufbauen bzw. Ausbilden von wenigstens einer weiteren Schicht bzw. Lage (24, 36) des Leiterplattenelements, ein Strukturieren wenigstens einer Schicht bzw. Lage (24, 36) des Leiterplattenelements, ein Festlegen von und/oder Bestücken mit wenigstens einem aktiven oder passiven Bauteil (24) auf bzw. in dem Leiterplattenelement vorgenommen wird bzw. werden.

5. Verfahren nach einem der Ansprüche 1 bis 4, **dadurch gekennzeichnet, dass** das Leiterplattenelement (2, 3, 4, 5, 12, 23, 32, 33, 34) von einem starren, flexiblen oder starr-flexiblen Leiterplattenelement, einem Leiterplatten-Zwischenprodukt bzw. -Halbfertigprodukt oder einer starren, flexiblen oder starrflexiblen Leiterplatte gebildet wird.

6. Verfahren nach einem der Ansprüche 1 bis 5, **dadurch gekennzeichnet, dass** eine Mehrzahl von Leiterplattenelementen (2, 3, 4, 5, 12, 23, 32, 33, 34) auf dem Träger (1, 11, 21, 31) angeordnet bzw. festgelegt wird und einem gemeinsamen Herstellungsvorgang, insbesondere Bearbeitungs- oder Bestückungsvorgang unterworfen wird.

7. Verfahren nach einem der Ansprüche 1 bis 6, **dadurch gekennzeichnet, dass** wenigstens zwei nebeneinander auf dem Träger (31) angeordnete Leiterplattenelemente (32, 33, 34) während der Herstellung, insbesondere Bearbeitung oder Bestückung miteinander verbunden werden.

8. Träger zur Verwendung in einem Verfahren gemäß einem der Ansprüche 1 bis 7, wobei der Träger (1, 11, 21, 31) mit einer haftenden Oberflächenchicht (6, 22, 35) zur Festlegung wenigstens eines Leiterplattenelements (2, 3, 4, 5, 12, 23, 32, 33, 34) oder Ausgangsmaterials hierfür ausgebildet ist, **dadurch gekennzeichnet, dass** die Oberfläche des Trägers (11) zur Anordnung eines Leiterplattenelements (12) mit einer zu einer von einer flachen Oberfläche abweichenden Außenoberfläche einer Leiterplatte komplementären Profilierung (14) in der Oberfläche des Trägermaterials ausgebildet ist.

9. Träger nach Anspruch 8, **dadurch gekennzeichnet, dass** das Material des Trägers (1, 11, 21, 31) gewählt ist aus Metallen, wie beispielsweise Aluminium, Stahl oder dgl., oder aus formstabilen und hochtemperaturfesten, insbesondere faserverstärkten Kunststoffen, wie Duroplasten oder Thermoplasten, wie beispielsweise Polyarylenen, Polyarylenether, Polyarylenetherketonen, Polyarylaten, Polyarylensulfiden, Polyarylenethersulfonen, Polyarylenamiden, Polyimiden.

10. Träger nach Anspruch 8 oder 9, **dadurch gekennzeichnet, dass** die haftende Oberfläche (6, 22, 35) des Trägers (1, 11, 21, 31) gebildet Ist von formstabilen und hochtemperaturfesten Kunststoffen, wie beispielsweise auspolymerisierten, adheslven, niedrigmolekularen Silikonharzen, wie insbesondere vernetzten Polymethylsiloxanen oder Polymethylphenylsiloxanen, etc.

## Claims

1. A method for producing, in particular processing or loading, a circuit board element, comprising the steps of
- providing a substantially full-area carrier (1, 11, 21, 31) having an adhering surface layer (6, 22, 35);
- disposing and fixing on said adhering surface (6, 22, 35) of the carrier (1, 11, 21, 31) a starting material of the circuit board element (2, 3, 4, 5, 12, 23, 32, 33, 34) to be produced, in particular processed or loaded;
- producing, in particular processing or loading, the circuit board element (2, 3, 4, 5, 12, 23, 32, 33, 34) fixed to the carrier (1, 11, 21, 31) in a position fixed on the carrier (1, 11, 21, 31); and
- removing the produced, in particular processed or loaded, circuit board element (2, 3, 4, 5, 12, 23, 32, 33, 34) from the carrier (1, 11, 21, 31),
**characterized in that** a circuit board element (12) configured with a surface deviating from a flat surface is disposed on the carrier (11) in a recess or depression (14) having a profile in the surface of the carrier material complementary to the surface contour of the circuit board element (12).

2. A method according to claim 1, **characterized in that** the circuit board element (2, 3, 4, 5, 12, 23, 32, 33, 34) is disposed on the adhering surface (6, 22, 35) of the carrier (1, 11, 21, 31) by referring to at least two marks (7, 15), in particular registration marks, provided in or on the circuit board element.

3. A method according to claim 1 or 2, **characterized in that**, during producing, in particular processing or loading, the circuit board element (2, 3, 4, 5, 12, 23, 32, 33, 34) together with the carrier (1, 11, 21, 31) is subjected to a treatment under elevated pressure and/or elevated temperature relative to ambient conditions.

4. A method according to claim 1, 2 or 3, **characterized in that**, during producing, in particular processing or loading, the circuit board element (2, 3, 4, 5, 12, 23, 32, 33, 34), mounting or forming at least one further layer or ply (24, 36) of the circuit board element, structuring at least one layer or ply (24, 36) of the circuit board element, fixing and/or inserting at least one active or passive component (24) on or in the circuit board element is/are performed.

5. A method according to any one of claims 1 to 4, **characterized in that** the circuit board element (2, 3, 4, 5, 12, 23, 32, 33, 34) is comprised of a rigid, flexible or rigid-flexible circuit board element, a circuit board intermediate product or semi-finished product, or a rigid, flexible or rigid-flexible circuit board.

6. A method according to any one of claims 1 to 5, **characterized in that** a plurality of circuit board elements (2, 3, 4, 5, 12, 23, 32, 33, 34) are disposed and/or fixed on the carrier (1, 11, 21, 31) and subjected to a joint production operation, in particular processing or loading operation.

7. A method according to any one of claims 1 to 6, **characterized in that** at least two circuit board elements (32, 33, 34) that are arranged next to each other on the carrier (31) are connected to each other during producing, in particular processing or loading.

8. A carrier for use in a method according to any one of claims 1 to 7, wherein the carrier (1, 11, 21, 31) is formed with an adhering surface layer (6, 22, 35) for fixing at least one circuit board element (2, 3, 4, 5, 12, 23, 32, 33, 34) or starting material for the same, **characterized in that** the surface of the carrier (11) for the arrangement of a circuit board element (12) is formed with a profile (14) in the surface of the carrier material that is complementary to a circuit board external surface deviating from a flat surface.

9. A carrier according to claim 8, **characterized in that** the material for the carrier (1, 11, 21, 31) is selected from metals such as aluminum, steel or the like, or from dimensionally stable and high-temperature-resistant, in particular fiber-reinforced, synthetic materials such as duroplasts or thermoplasts like, e.g., polyarylenes, polyarylene ether, polyarylene ether ketones, polyarylates, polyarylene sulfides, polyarylene ether sulfones, polyarylene amides, polyimides.

10. A carrier according to claim 8 or 9, **characterized in that** the adhering surface (6, 22, 35) of the carrier (1, 11, 21, 31) is formed by dimensionally stable and high-temperature-resistant synthetic materials such as, e.g., polymerized adhesive low-molecular silicone resins such as, in particular, cross-linked polymethyl siloxanes or polymethylphenyl siloxanes, etc.

## Revendications

1. Procédé servant à fabriquer, en particulier à usiner ou à équiper, un élément de carte de circuits imprimés, comprenant les étapes suivantes :
- mettre à disposition un support (1, 11, 21, 31) essentiellement à surface pleine comprenant une couche de surface adhésive (6, 22, 35),
- disposer et fixer un matériau de départ de l'élément de carte de circuits imprimés (2, 3, 4, 5, 12, 23, 32, 33, 34) à fabriquer, en particulier à usiner ou à équiper, sur la surface adhésive (6, 22, 35) du support (1, 11, 21, 31),
- fabriquer, en particulier usiner ou équiper, l'élément de carte de circuits imprimés (2, 3, 4, 5, 12, 23, 32, 33, 34) fixé sur le support (1, 11, 21, 31) dans une position fixée sur le support (1, 11, 21, 31), et
- retirer du support (1, 11, 21, 31) l'élément de carte de circuits imprimés (2, 3, 4, 5, 12, 23, 32, 33, 34) fabriqué, en particulier usiné ou équipé,
**caractérisé en ce qu'**un élément de carte de circuits imprimés (12), réalisé avec une surface différente d'une surface plane, sur le support (11) est disposé dans la surface du matériau de support dans un évidement ou renfoncement (14) présentant un profilage complémentaire par rapport au contour de surface de l'élément de carte de circuits imprimés (12).

2. Procédé selon la revendication 1, **caractérisé en ce que** l'élément de carte de circuits imprimés (2, 3, 4, 5, 12, 23, 32, 33, 34) est disposé sur la surface adhésive (6, 22, 35) du support (1, 11, 21, 31) en prenant référence par rapport au moins à deux repères (7, 15), en particulier des repères d'enregistrement, prévus dans ou au niveau de l'élément de carte de circuits imprimés.

3. Procédé selon la revendication 1 ou 2, **caractérisé en ce que** l'élément de carte de circuits imprimés (2, 3, 4, 5, 12, 23, 32, 33, 34) est soumis, conjointement avec le support (1, 11, 21, 31), lors de la fabrication, en particulier lors de l'usinage ou de l'équipement, à un traitement réalisé à une pression plus élevée et/ou à une température plus élevée par rapport aux conditions environnantes.

4. Procédé selon la revendication 1, 2 ou 3, **caractérisé en ce que**, lors de la fabrication, en particulier de l'usinage ou de l'équipement, de l'élément de carte de circuits imprimés (2, 3, 4, 5, 12, 23, 32, 33, 34), sont effectués une confection ou réalisation d'au moins une autre couche ou strate (24, 36) de l'élément de carte de circuits imprimés, une structuration d'au moins une couche ou strate (24, 36) de l'élément de carte de circuits imprimés, une fixation de et/ou un équipement avec au moins un composant (24) actif ou passif sur ou dans l'élément de carte de circuits imprimés.

5. Procédé selon l'une quelconque des revendications 1 à 4, **caractérisé en ce que** l'élément de carte de circuits imprimés (2, 3, 4, 5, 12, 23, 32, 33, 34) est formé par un élément de carte de circuits imprimés rigide, flexible ou rigide et flexible, par un produit intermédiaire ou un semi-produit de carte de circuits imprimés ou par une carte de circuits imprimés rigide, flexible ou rigide et flexible.

6. Procédé selon l'une quelconque des revendications 1 à 5, **caractérisé en ce qu'**une pluralité d'éléments de carte de circuits imprimés (2, 3, 4, 5, 12, 23, 32, 33, 34) est disposée ou fixée sur le support (1, 11, 21, 31) et est soumise à une opération de fabrication commune, en particulier à une opération d'usinage ou d'équipement.

7. Procédé selon l'une quelconque des revendications 1 à 6, **caractérisé en ce qu'**au moins deux éléments de carte de circuits imprimés (32, 33, 34) disposés de manière juxtaposée sur le support (31) sont reliés entre eux au cours de la fabrication, en particulier au cours de l'usinage ou de l'équipement.

8. Support destiné à être utilisé dans un procédé selon l'une quelconque des revendications 1 à 7, le support (1, 11, 21, 31) étant réalisé avec une couche de surface adhésive (6, 22, 35) servant à fixer au moins un élément de carte de circuits imprimés (2, 3, 4, 5, 12, 23, 32, 33, 34) ou un matériau de départ à cet effet, **caractérisé en ce que** la surface du support (11) est réalisée dans la surface du matériau de support afin de disposer un élément de carte de circuits imprimés (12) avec un profilage (14) complémentaire à une surface extérieure, différente d'une surface plate, d'une carte de circuits imprimés.

9. Support selon la revendication 8, **caractérisé en ce que** le matériau du support (1, 11, 21, 31) est choisi parmi des métaux, tels que par exemple l'aluminium, l'acier ou similaire, ou parmi des matières en plastique de forme stable et résistantes à des températures élevées, en particulier renforcées par des fibres, telles que les matières thermodurcissables ou thermoplastiques, telles que par exemple les polyarylènes, les polyarylèneéthers, les polyarylènes éther-cétone, les polyarylates, les sulfures de polyarylène, les polyarylèneéthersulfones, les amides de polyarylène, les polyimides.

10. Support selon la revendication 8 ou 9, **caractérisé en ce que** la surface adhésive (6, 22, 35) du support (1, 11, 21, 31) est formée par des matières en plastique de forme stable et résistantes à des températures élevées, telles que par exemple des résines de silicone polymérisées, adhésives, à faible poids moléculaire, telles qu'en particulier des polyméthylsiloxanes ou des siloxanes de polyméthylphényle réticulés, etc.
